# FASCICULE DE BREVET EUROPEEN

(11) **EP 1 075 098 B1**
(45) Date de publication et mention de la délivrance du brevet: **18.10.2006**
(21) Numéro de dépôt: 99115319.8
(22) Date de dépôt: 03.08.1999
(51) Int. Cl.: H04B 11/00, G01H 11/08, B06B 1/02, G04G 1/00, H03M 1/60

(54) **Convertisseur électronique d'un signal acoustique en un signal pseudo-numérique et procédé de communication bidirectionnelle par ondes acoustiques**
Elektronischer Wandler eines akustischen Signals in ein pseudo-digitales Signal und bidirektionelles Kommunikationsverfahren durch Schallwellen
Electronic converter of an acoustic signal to a pseudo-digital signal and bidirectional communication method by acoustic waves

(43) Date de publication de la demande: 07.02.2001
(73) Titulaire: ETA SA Manufacture Horlogère Suisse, 2540 Grenchen (CH)
(72) Inventeur: Fleury, Emmanuel, 2740 Moutier (CH); Blondeau, Fabien, 2525 Le Landeron (CH)
(74) Mandataire: Ravenel, Thierry Gérard Louis

(56) Documents cités:
- WO-A-95/22065
- CH-A- 641 625
- DE-A- 3 618 222
- US-A- 3 989 963
- US-A- 5 719 825
- PATENT ABSTRACTS OF JAPAN vol. 008, no. 058 (P-261), 16 mars 1984 (1984-03-16) & JP 58 206989 A (YOKOGAWA DENKI SEISAKUSHO KK), 2 décembre 1983 (1983-12-02)

## Description

La présente invention concerne un convertisseur électronique d'un signal acoustique en un signal pseudo-numérique, notamment pour commander un microprocesseur, ainsi qu'une pièce d'horlogerie comportant un tel convertisseur. L'invention concerne également un procédé de communication bidirectionnelle par ondes acoustiques entre un instrument émetteur et un instrument récepteur.

On connaît par le brevet US 5,848,027 au nom de Biometrics, Inc., un système pour le traitement de données personnelles. Ce système permet, par exemple, de contrôler les performances d'un athlète tel qu'un coureur à pieds. Il permet d'enregistrer la date et l'heure de la course, le temps réalisé à chaque tour de piste, ou encore le temps final accompli par le sportif. Le système permet également d'enregistrer les valeurs de certains paramètres physiologiques tels que le rythme cardiaque ou un électrocardiogramme (ECG) qui reflètent l'effort fourni par l'athlète au cours de son activité sportive. Toutes ces informations vont ensuite être transmises, via une liaison sonore, à un ordinateur personnel dans lequel ces données vont être traitées, analysées, puis finalement affichées à l'écran dudit ordinateur

On a représenté à la figure 1 annexée à la présente demande de brevet un exemple préféré de réalisation du système Biometrics cité ci-dessus. Ce système comprend un objet portable tel qu'une pièce d'horlogerie 1, par exemple une montre-bracelet à affichage digital, apte à stocker des données et à les transmettre ultérieurement. Ces données peuvent être transmises à un ordinateur personnel 2 sous forme de "bips" sonores produisant une pression acoustique 4 qui va être captée par un microphone 6. La pièce d'horlogerie peut être tout type d'instrument digital commandé par un microprocesseur et contenant un élément piézo-électrique apte à produire des "bips" sonores pour la transmission des informations. L'ordinateur personnel 2 est équipé d'une carte son 8 reliée au microphone 6 par un câble 10. L'ordinateur est ainsi capable de capter la pression acoustique 4 engendrée par les "bips" sonores émis par la pièce d'horlogerie 1. Ledit ordinateur 2 peut également être équipé d'un écran d'affichage 2.

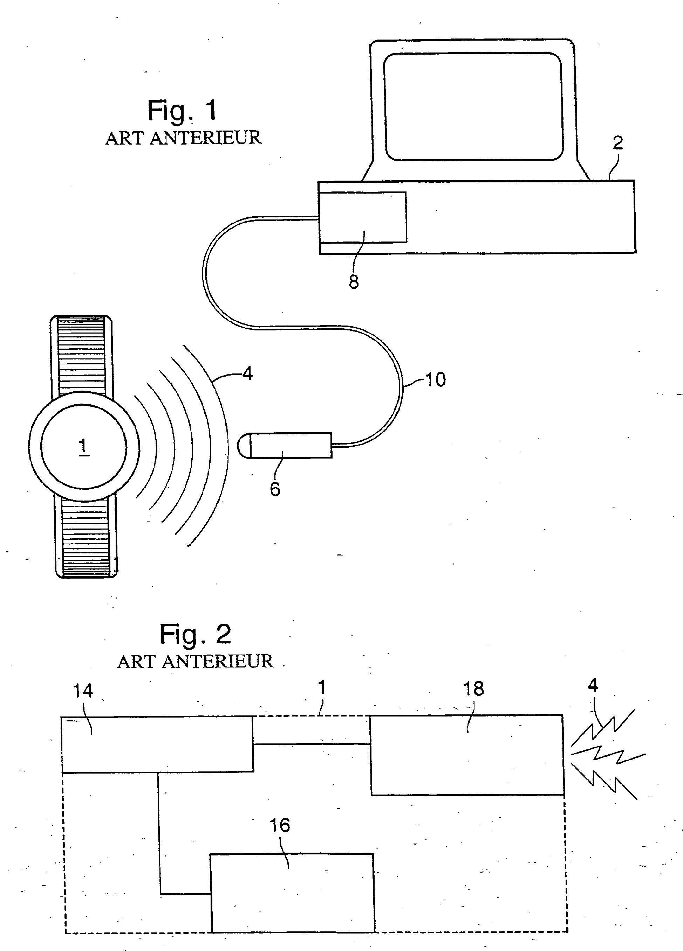

Comme représenté à la figure 2 de la présente demande, la pièce d'horlogerie 1 comprend un microprocesseur interne 14 qui fournit la base de temps à ladite pièce d'horlogerie 1. Le microprocesseur 14 peut également commander un programme de mémorisation 16 coopérant avec une mémoire interne à accès aléatoire. D'autre part, un élément piézo-électrique 18 est apte à produire à sa sortie une tonalité présélectionnée. L'élément piézo-électrique 18 est ainsi utilisé pour fournir les "bips" sonores semblables à ceux produits par les dispositifs générateurs de son dans la plupart des montres digitales équipées d'une alarme.

Le système Biometrics susdécrit permet avantageusement d'enregistrer des données personnelles dans une montre, puis de transférer ces données par ondes sonores vers un ordinateur où elles vont être traitées et analysées. Ce système n'est malheureusement pas bidirectionnel. Il n'est donc pas possible de transférer des informations depuis l'ordinateur vers la montre, ce qui limite considérablement les applications possibles du système Biometrics.

On connaît par ailleurs le brevet CH 641 625 au nom de Seikosha, Tokyo (JP) qui décrit un circuit électrique pour entraîner un vibreur piézo-électrique.

Les figures 3 et 4 annexées à la présente demande de brevet représentent, respectivement par un schéma électrique et par des diagrammes d'évolution des niveaux de tension en fonction du temps, la constitution et le mode de fonctionnement d'un circuit d'entraînement classique pour un vibreur piézo-électrique.

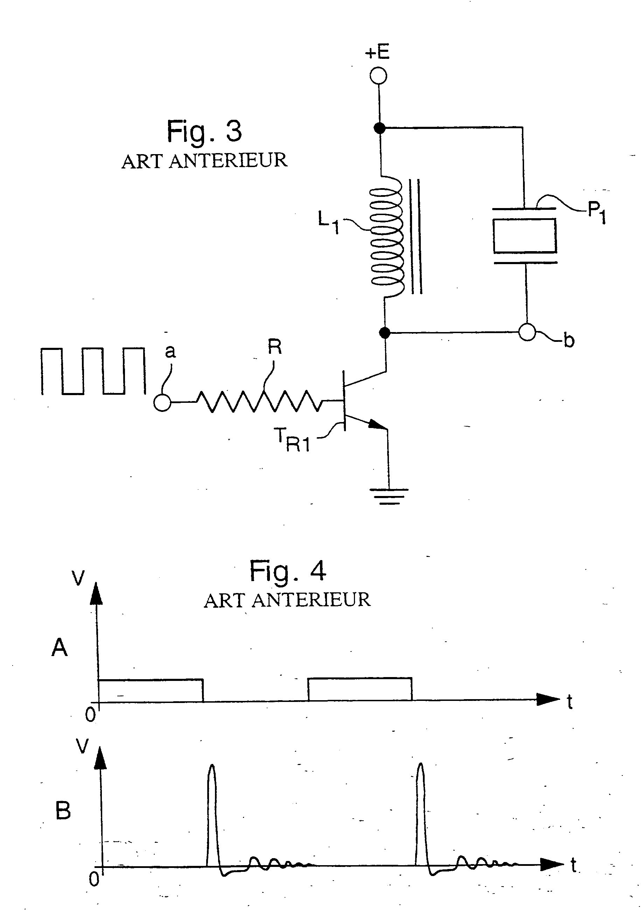

Le circuit électrique dont le schéma est représenté à la figure 3 comprend, branchée sur la sortie d'un transistor T_{R1} alternativement passant et bloqué, une bobine L₁. Un vibreur piézo-électrique P₁ est raccordé en parallèle sur la bobine L₁. Ce circuit électrique reçoit, sur une connexion d'entrée "a", un signal de commande impulsionnel à créneaux correspondant à ce que montre la courbe A de la figure 4 dont l'abscisse représente le temps "t" et l'ordonnée la tension "v". Depuis la borne d'entrée "a", ce signal est appliqué à la base du transistor T_{R1} par l'intermédiaire d'une résistance R. Lorsque le transistor T_{R1} est maintenu passant par l'impulsion du signal de commande, un courant électrique circule à travers la bobine L₁ depuis une source de tension continue +E, tandis que la connexion "b" du vibreur piézo-électrique P₁ est reliée à la masse du circuit électrique selon ce que montre la courbe B de la figure 4 (qui présente le temps "t" en abscisse et la tension "v" en ordonnée).

Il est à noter qu'aussi longtemps que le transistor T_{R1} est passant, il ne circule aucun courant dans le vibreur piézo-électrique P₁. Ce dernier se comporte en effet comme un condensateur. Or, le courant "i" délivré par un condensateur est égal au produit C*dE/dt, où C est la valeur de la capacité du condensateur, et E la tension aux bornes de ce dernier. Dans le cas présent, E étant une tension continue, sa dérivée par rapport au temps est nulle, et le courant qui circule dans le vibreur piézo-électrique P₁ est également nul. On peut aussi noter que la tension "v" aux bornes de la bobine L₁ est donnée par la relation v = -L*di/dt = E, où L est la valeur de l'inductance de ladite bobine L₁, et "i" est le courant qui traverse cette dernière. En conséquence, le produit L*di/dt est constant, ce qui signifie qu'aussi longtemps que le transistor T_{R1} est maintenu passant, le courant qui circule dans la bobine L₁ croît linéairement.

Au moment où le transistor T_{R1} passe à l'état bloqué lors du front descendant de chaque impulsion de la forme d'onde A, toute l'énergie accumulée dans la bobine est transmise aux bornes du vibreur piézo-électrique, chargeant celui-ci à une tension bien supérieure à la tension d'alimentation, et dans le sens inverse. Comme on peut le voir sur la forme d'onde B de la figure 4, cette tension oscillante présente une première impulsion positive de forte amplitude, suivie d'une deuxième impulsion négative très fortement amortie. Ce fort amortissement est dû au fait que la tension au point de connexion "b" qui est relié au collecteur du transistor T_{R1} ne peut excéder, durant l'alternance négative, la tension de blocage de la diode P-N qui constitue ce collecteur, tension de blocage dont la valeur est habituellement de l'ordre de 0,6 V. Ainsi, l'énergie électrique efficace qui fait fonctionner le vibreur piézo-électrique P₁ est donnée seulement par l'impulsion initiale qui est de faible durée, de sorte qu'il est difficile d'obtenir une forte excitation dudit vibreur P₁. C'est pour cette raison que l'on se heurte à l'inconvénient de ne pas pouvoir obtenir un niveau de pression sonore suffisamment élevé.

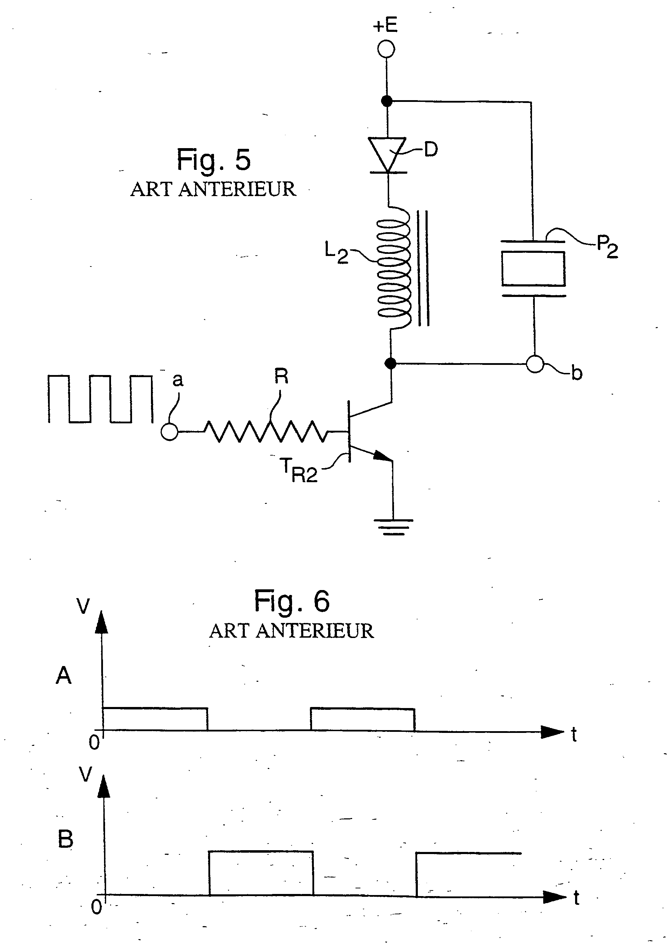

Les figures 5 et 6 annexées à la présente demande de brevet représentent la solution apportée par Seikosha au problème mentionné ci-dessus. La figure 5 est un schéma représentant un circuit électrique d'entraînement d'un vibreur piézo-électrique constituant une forme d'exécution de invention Seikosha. La figure 6 est un diagramme des niveaux de tension en fonction du temps en deux endroits du circuit de la figure 5.

Le circuit électrique dont le schéma est représenté à la figure 5 comprend une bobine L₂ et une diode D branchées en série sur la sortie d'un transistor T_{R2}. Un vibreur piézo-électrique P₂ est raccordé en parallèle sur ce branchement série.

Au moment où le transistor T_{R2} passe à l'état bloqué lors du front descendant de chaque impulsion du signal de commande en créneaux (courbe A, figure 6), une tension est induite dans la bobine L₂ et est appliquée, par l'intermédiaire de la diode D qui reste polarisée dans le sens passant, aux bornes du vibreur piézo-électrique P₂ (courbe B, figure 6). La tension aux bornes du vibreur P₂ reste ensuite bloquée à son niveau maximum car, lors du début de l'impulsion de tension inverse dans la bobine L₂, la diode D se trouve polarisée dans le sens non passant et bloque le retour du courant. Comme on peut le voir en comparant les niveaux de tension B des figures 4 et 6, l'énergie qui est fournie au vibreur piézo-électrique P₂ est beaucoup plus grande que celle qui était fournie au vibreur piézo-électrique P₁ de l'art antérieur.

En conséquence, l'invention Seikosha permet une augmentation sensible du niveau de pression acoustique. Toutefois, cette invention ne suggère pas l'utilisation d'un vibreur piézo-électrique pour la réception et la numérisation de trains d'ondes sonores.

La demande de brevet DE 36 18 222 A décrit un convertisseur électronique comprenant un circuit générateur de son muni d'un vibreur piézo-électrique ainsi que des moyens fournissant une tension de référence et des moyens de comparaison qui comparent la tension de référence à la tension produite par le vibreur piézo-électrique lorsque celui-ci capte une onde acoustique et un procédé utilisant un émetteur/récepteur comportant un tel convertisseur. Le préambule de la revendication 1 est derivé de ce document qui est considerée étant l'état de la technique le plus proche.

La présente invention a pour but de remédier aux problèmes et inconvénients ci-dessus ainsi qu'à d'autres encore en proposant un convertisseur électronique d'un signal acoustique en un signal pseudo-numérique permettant de faire fonctionner un circuit d'entraînement d'un vibreur piézo-électrique à la façon d'un capteur d'ondes acoustiques, et de transformer ces trains d'ondes en impulsions numériques.

On utilise un circuit générateur de son comprenant un vibreur piézo-électrique comme récepteur d'ondes acoustiques.

Le circuit générateur de son comprend des moyens de commutation agencés pour s'enclencher et se déclencher sur réception d'un signal de commande, ainsi qu'une branche de circuit dans laquelle une bobine et une diode sont montées en série, une résistance et le vibreur piézo-électrique étant raccordés en parallèle sur ladite branche de circuit.

Il est possible d'utiliser comme récepteur d'ondes acoustiques un circuit électrique qui, à l'origine, était uniquement conçu pour entraîner un vibreur piézo-électrique employé comme générateur de son dans les montres électroniques munies d'un dispositif d'alarme. II n'est pas nécessaire de modifier le circuit d'entraînement du vibreur, ce qui permet de réaliser des économies substantielles en termes de coûts de fabrication, et de proposer un circuit fiable et de faible encombrement.

Selon un aspect, la présente invention concerne un convertisseur électronique d'un signal acoustique en un signal pseudo-numérique, ledit convertisseur électronique comprenant un circuit générateur de son muni d'un vibreur piézo-électrique ainsi que des moyens fournissant une tension de référence et des moyens de comparaison qui comparent la tension de référence à la tension produite par le vibreur piézo-électrique lorsque celui-ci capte une onde acoustique, caractérisé en ce que lesdits moyens de comparaison produisent un signal pseudo-numérique lorsque la tension produite par ledit vibreur excède ladite tension de référence.

Grâce à ces caractéristiques, on peut non seulement produire un son, mais également capter un tel son et le transformer en un niveau de tension logique apte à être utilisé pour commander un microprocesseur. Dès lors, il devient possible d'envisager l'échange par ondes acoustiques de tous types d'informations entre deux objets distants tels que, par exemple, deux montres-bracelets ou une montre-bracelet et un ordinateur, moyennant uniquement l'adjonction au circuit d'entraînement du vibreur piézo-électrique d'un circuit comparateur. On obtient ainsi un système de communication bidirectionnelle par ondes acoustiques beaucoup plus simple et bien moins encombrant que les systèmes de communication sans fil, par exemple par infrarouge ou par radiofréquence, connus actuellement.

La présente invention concerne également une pièce d'horlogerie comportant un circuit convertisseur tel que décrit ci-dessus.

La présente invention concerne enfin un procédé de communication bidirectionnelle par ondes acoustiques entre un instrument émetteur et un instrument récepteur, chacun de ces deux instruments comportant un microprocesseur et un convertisseur électronique, ledit convertisseur comprenant un circuit générateur de son muni d'un vibreur piézo-éloctrique ainsi que des moyens fournissant une tension de référence, où
- le circuit générateur de son comprend des moyens de commutation agencés pour s'enclencher et se déclencher sur réception d'un signal impulsionnel de commande;
- le convertisseur électronique comprend en outre des moyens de comparaison qui comparent la tension de référence à la tension produite par le vibreur piézo-électrique lorsque celui-ci capte une onde acoustique, ces moyens de comparaison produisant un signal pseudo-numérique formé d'une succession d'impulsions logiques lorsque la tension produite par ledit vibreur excède la tension de référence;
- aussi longtemps que l'émetteur et le récepteur sont au repos, le microprocesseur du récepteur reste en attente d'un signal sonore;
- dès que l'émetteur envoie le premier d'une série de "bips" sonores successifs, le microprocesseur du récepteur commande le démarrage d'un compteur de temps, et commence à compter le nombre d'impulsions logiques produites par les moyens de comparaison, de sorte que ledit microprocesseur peut calculer le nombre d'impulsions reçues dans un intervalle de temps donné, et déterminer par lecture dans un compteur s'il s'agit d'un niveau logique "0" ou "1".

Selon une caractéristique complémentaire de l'invention, le procédé est caractérisé en ce que chaque niveau logique "0" ou "1" correspond à un "bip" long ou à un "bip" court, deux "bips" sonores successifs étant séparés par une plage de silence pendant laquelle l'émetteur n'émet pas.

D'autres caractéristiques et avantages de la présente invention apparaîtront plus clairement à la lecture de la description détaillée qui suit d'un exemple de réalisation du convertisseur électronique selon l'invention, cet exemple étant donné à titre purement illustratif et non limitatif, en liaison avec les dessins annexés dans lesquels:
- la figure 1, déjà citée, représente une pièce d'horlogerie pouvant enregistrer des données personnelles, puis transmettre ces informations à un ordinateur via une liaison sonore;
- la figure 2, déjà citée, est un schéma bloc d'une pièce d'horlogerie telle que représentée à la figure 1, comprenant un programme de traitement des données, ainsi que des moyens de mémorisation et de transmission de ces données;
- les figures 3 et 4, déjà citées, représentent respectivement par un schéma électrique et par des diagrammes d'évolution des niveaux de tension en fonction du temps, la constitution et le mode de fonctionnement d'une première forme de réalisation d'un circuit d'entraînement d'un vibreur piézo-électrique;
- la figure 5, déjà citée, représente le schéma d'une seconde variante de réalisation d'un circuit d'entraînement d'un vibreur piézo-électrique;
- la figure 6, déjà citée, est un diagramme des niveaux de tension en fonction du temps en deux endroits du circuit de la figure 5;
- la figure 7 représente un schéma électrique d'un circuit convertisseur d'un signal acoustique en un signal pseudo-numérique conforme à la présente invention;
- la figure 8 représente les niveaux de tension en fonction du temps en deux endroits du circuit de la figure 7;
- la figure 9 représente les niveaux de tension en fonction du temps en deux endroits du circuit de la figure 7 lorsque ce circuit est utilisé comme récepteur d'ondes sonores;
- la figure 10 représente un schéma électrique de deux circuits convertisseurs conformes à la présente invention, disposés côte à côte afin de déterminer la fonction de transfert en fréquence du système acoustique que constituent ces deux convertisseurs;
- la figure 11 est une représentation graphique de la fonction de transfert en fréquence du système de la figure 10;
- la figure 12 est une représentation schématique de deux montres-bracelets électroniques qui échangent entre elles des informations par ondes sonores;
- les figures 13A et 13B représentent respectivement l'enveloppe du signal sonore émis par une montre émettrice, ainsi que la tension impulsionnelle de commande à créneaux appliquée au transistor de commutation de cette montre;
- la figure 14 représente les niveaux de tension au point de connexion du vibreur piézo-électrique et en sortie du convertisseur analogique-numérique dans la montre réceptrice, et
- la figure 15 est une représentation graphique du principe de codage à modulation de la fréquence "FSK" (Frequency Shift Keying).

On utilise comme récepteur d'ondes acoustiques un vibreur piézo-électrique habituellement employé comme générateur de son dans les montres électroniques comportant un dispositif d'alarme. L'invention consiste à brancher ledit vibreur piézo-électrique aux bornes d'un comparateur électronique qui produit à sa sortie un signal pseudo-numérique représentatif du signal sonore incident capté par le vibreur et permettant de commander, par exemple, les fonctions d'un microprocesseur.

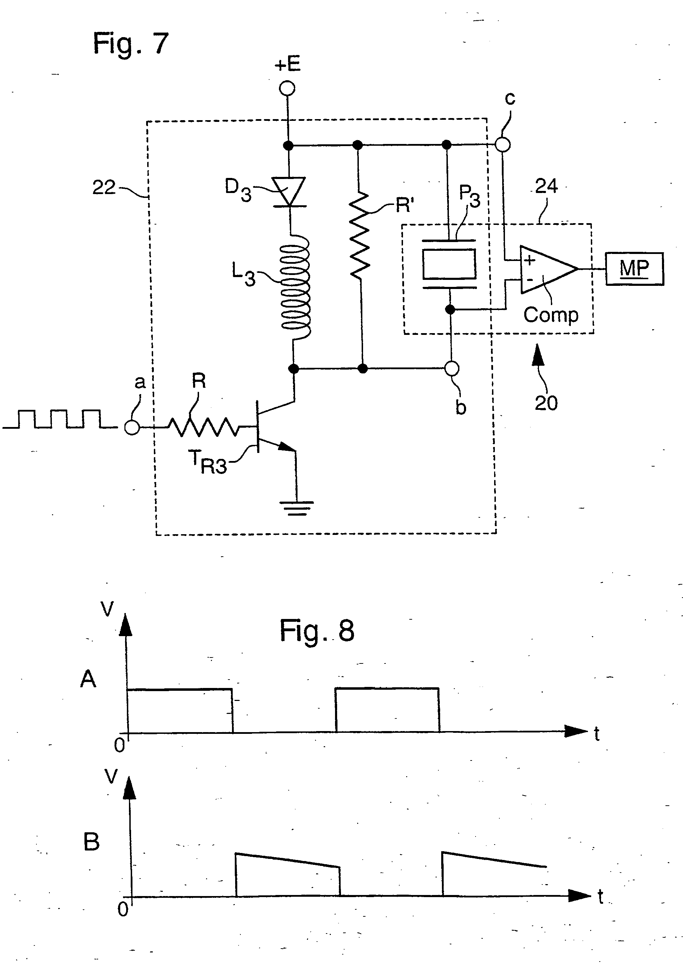

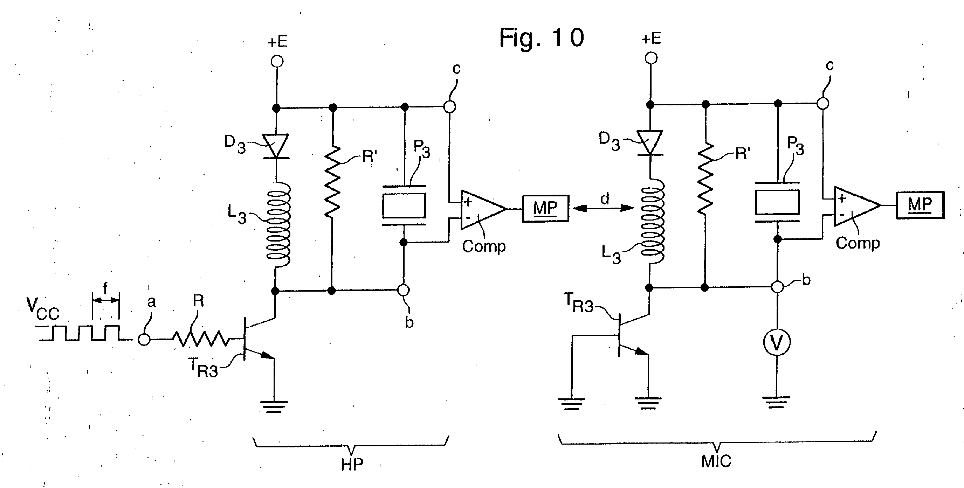

La figure 7 représente le convertisseur électronique conforme à la présente invention et désigné dans son ensemble par la référence numérique générale 20. Comme il ressort de la figure 7, le convertisseur électronique 20 susmentionné est constitué par l'association d'un circuit d'entraînement 22 d'un vibreur piézo-électrique P₃ et d'un circuit de comparaison 24 dont les principes de fonctionnement respectifs vont être décrits ci-dessous.

Le circuit d'entraînement 22 du vibreur piézo-électrique P₃ comprend une branche de circuit dans laquelle une bobine L₃ et une diode D₃ sont montées en série, une résistance R' et le vibreur piézo-électrique P₃ étant branchés en parallèle sur cette branche de circuit.

Le mode de fonctionnement du circuit d'entraînement 22 ayant déjà été analysé en détail dans la partie introductive de la présente demande de brevet consacrée à l'état de la technique, on se contentera ici d'en rappeler brièvement les principales caractéristiques. Le circuit d'entraînement 22 reçoit sur une borne d'entrée "a" un signal impulsionnel de commande à créneaux "v" (courbe A, figure 8). Ce signal de commande est appliqué à travers une résistance R à la base d'un transistor T_{R3}. Lorsque le transistor T_{R3} est rendu passant par une impulsion de commande, la bobine L₃ est parcourue par un courant fourni par une source de tension continue +E, tandis que le point de connexion "b" du vibreur piézo-électrique P₃ est relié à la masse du circuit d'entraînement 22. Lorsque le transistor T_{R3} passe à l'état bloqué lors du front descendant de chaque impulsion de commande, toute l'énergie accumulée dans la bobine L₃ est transmise aux bornes du vibreur P₃, chargeant celui-ci à une tension "v" (courbe B, figure 8) supérieure à la tension d'alimentation +E. Lorsqu'à son tour le vibreur P₃ commence à se décharger, la diode D₃ bloque le retour du courant. L'énergie qui est fournie audit vibreur P₃ est donc très grande. On notera qu'entre deux signaux impulsionnels de commande successifs, le vibreur piézo-électrique P₃ peut tout de même se décharger partiellement à travers la résistance R'. Ainsi, lorsque plus aucun signal de commande n'est appliqué au transistor T_{R3}, et que celui-ci se trouve donc à l'état bloqué, la tension aux bornes du vibreur P₃ retrouve progressivement sa valeur de repos +E.

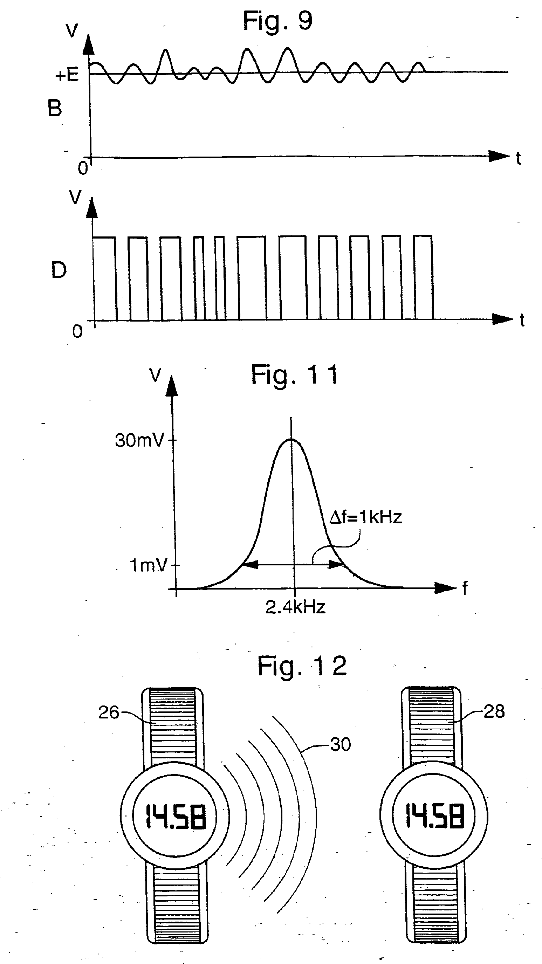

On examine maintenant le fonctionnement du circuit de comparaison 24. Celui-ci comprend des moyens constitués, dans l'exemple représenté à la figure 7, par un comparateur analogique-digital COMP. L'une des entrées du comparateur COMP est reliée à des moyens fournissant une tension de référence. A titre d'exemple non limitatif, la première entrée du comparateur COMP est reliée au point de connexion "c" de la source d'alimentation continue +E, tandis que l'autre entrée dudit comparateur COMP est reliée au point de sortie "b" du circuit d'entraînement 22, autrement dit au point de connexion entre le vibreur piézo-électrique P₃ et le transistor T_{R3}. Comme déjà précisé ci-dessus, en l'absence de signal de commande appliqué sur la base du transistor T_{R3}, le vibreur P₃ est au repos et la tension à ses bornes est égale à la tension d'alimentation +E (courbe B, figure 9). Dans ces conditions, le vibreur piézo-électrique P₃ n'est plus utilisé comme générateur de son mais peut, au contraire, être employé comme récepteur d'ondes acoustiques. Sous l'effet d'un signal sonore incident, la tension aux bornes du vibreur P₃ va se mettre à osciller de part et d'autre de sa tension de repos +E, comme le montre la courbe B de la figure 9. On comprendra que l'énergie produite dans le vibreur piézo-électrique P₃ par une onde acoustique incidente pourrait être susceptible de se dissiper dans la bobine L₃, de sorte qu'elle ne serait plus disponible aux bornes dudit vibreur P₃, ce qui conduirait à un niveau de tension faible au point de connexion "b" avec le comparateur COMP, et donc à une plus grande sensibilité au bruit. Toutefois, la diode D₃ montée en série avec la bobine L₃ a pour avantage de présenter une impédance très élevée, ce qui équivaut à un circuit ouvert, et permet ainsi d'éviter que le vibreur P₃ ne se décharge. Le comparateur COMP compare ensuite la tension produite par ledit vibreur P₃ avec sa tension de référence qui est la tension d'alimentation +E du circuit d'entraînement 22. A chaque fois que la tension produite par le vibreur piézo-électrique P₃ excède la tension +E, le comparateur COMP va produire un signal impulsionnel à sa sortie "d" (courbe D, figure 9). Il est ainsi possible, grâce à la présente invention, de transformer un signal sonore en un signal électrique pseudo-numérique, en utilisant un circuit classique d'entraînement d'un vibreur piézo-électrique, et en raccordant simplement aux bornes de ce circuit un comparateur analogique-numérique. Le signal pseudo-numérique va ensuite être utilisé pour commander un microprocesseur MP comme il sera décrit en détail ultérieurement. On pourra noter que, comme le montre la courbe D de la figure 9, le comparateur COMP a un potentiel en sortie qui varie entre sa tension d'alimentation positive +E, et sa tension d'alimentation négative, c'est-à-dire la masse du circuit convertisseur 20 selon l'invention.

On a représenté sur la figure 10 deux circuits convertisseurs 20 identiques disposés à une distance "d" l'un de l'autre. L'un de ces circuits convertisseurs 20 fonctionne comme générateur de son (on dira encore qu'il fonctionne en mode haut-parleur HP), tandis que l'autre circuit convertisseur 20 fonctionne comme récepteur de son (on dira encore qu'il fonctionne en mode microphone MIC). On applique à la base du transistor T_{R3} du circuit convertisseur HP un signal de commande impulsionnel à créneaux V_{CC}. Le circuit convertisseur MIC doit quant à lui être totalement passif. Le transistor T_{R3} du circuit MIC doit donc se trouver à l'état bloqué, c'est-à-dire qu'aucune tension ne doit être appliquée sur sa base. On comprendra aisément qu'en faisant varier la fréquence "f" du signal de commande V_{CC} appliqué au transistor T_{R3} du circuit HP, on fait varier la fréquence du son produit par ce circuit. Dans le même temps, on mesure au moyen d'un voltmètre V la réponse du vibreur piézo-électrique P₃ du circuit MIC au signal sonore produit par le circuit HP. On obtient ainsi (voir figure 11) la caractéristique de transfert en fonction de la fréquence de deux circuits convertisseurs selon l'invention, dont l'un émet un signal sonore (circuit convertisseur HP), et dont l'autre reçoit ce signal sonore (circuit convertisseur MIC), ceci pour une distance "d" et une tension de commande V_{CC} données. On pourra noter que la mesure ainsi obtenue tient compte, non seulement de la caractéristique de transfert du circuit MIC (qui peut être obtenue lors d'une mesure de la réponse en fréquence de celui-ci), mais aussi de la caractéristique de transfert du circuit HP et de son amplificateur constitué des éléments diode D₃, transistor T_{R3} et bobine L₃. On pourra également noter que la caractéristique de transfert dépend fortement des caractéristiques des vibreurs piézo-électriques utilisés dans les circuits MIC et HP.

Comme on pourra le constater à l'examen de la figure 11, la réponse du système constitué des deux circuits HP et MIC est optimale pour une fréquence située au voisinage de f = 2,4 kHz du signal de commande V_{CC} appliqué au transistor T_{R3} du circuit HP. A cette fréquence, la tension produite par le vibreur piézo-électrique P₃ du circuit MIC à son point de connexion "b" est de l'ordre de 30 mV. On constatera, d'autre part, que la largeur de la bande passante du système HP/MIC pour une tension de 1 mV est de l'ordre de Δf = 1 kHz. Ces résultats sont obtenus avec les valeurs suivantes des différents paramètres :
- distance "d" entre les deux circuits HP et MIC voisine de zéro;
- tension de commande V_{CC} = 3 V;
- capacité des vibreurs piézo-électriques P₃ de l'ordre de 10 nF, et
- inductance des bobines L₃ de l'ordre de 50 mH.

La figure 12 montre, de manière schématique, deux montres-bracelets électroniques 26 et 28 équipées chacune d'un circuit convertisseur 20 conforme à la présente invention, l'une quelconque de ces deux montres 26 ou 28 étant capable de capter la pression acoustique 30 produite par les "bips" sonores provenant de l'autre montre. Il va de soi que l'exemple de deux montres-bracelets est donné à titre illustratif uniquement, et qu'il peut s'agir de tout type d'instrument digital commandé par un microprocesseur et contenant un élément piézo-électrique apte à produire et à capter des sons.

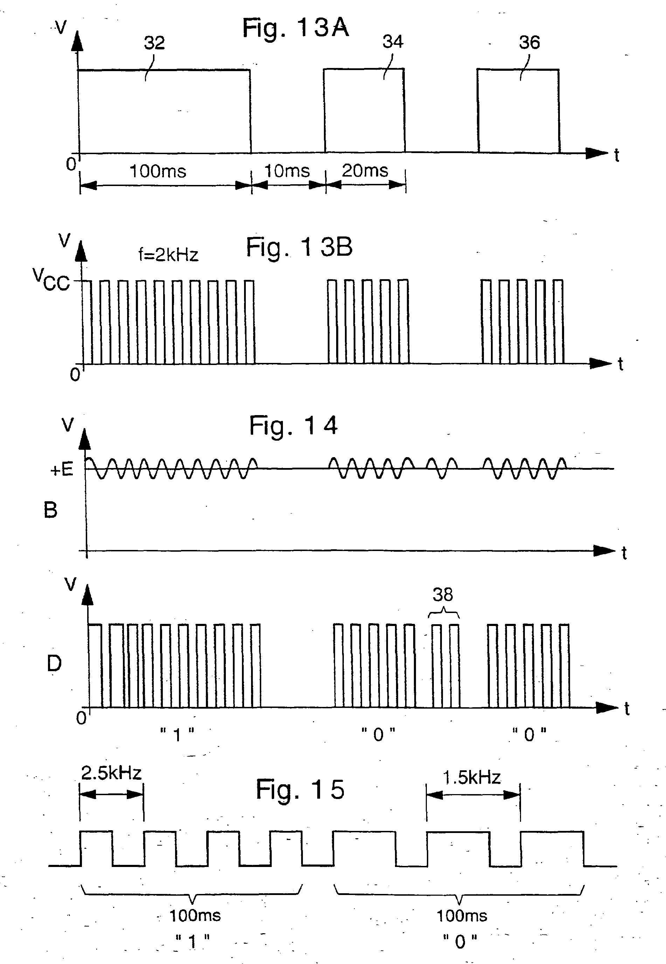

On suppose, par exemple, que la montre 26 fonctionne comme générateur de son et produit (voir figure 13A) un train d'ondes acoustiques comprenant un "bip" long 32 suivi de deux "bips" courts 34 et 36. Pour produire ce train d'ondes acoustiques, il faut appliquer à la base du transistor T_{R3} de la montre émettrice 26 un signal impulsionnel de commande à créneaux tel que représenté à la figure 13B.

La fréquence du signal impulsionnel de commande est par exemple choisie égale à 2 kHz, c'est-à-dire une valeur voisine de la fréquence optimale déterminée par la caractéristique de transfert des deux montres émettrice 26 et réceptrice 28. Le signal impulsionnel de commande est appliqué au transistor T_{R3} de la montre émettrice 26 par le microprocesseur MP de cette dernière. La montre émettrice 26 comprend une base de temps fournie par un oscillateur à quartz (non représenté) qui oscille typiquement à la fréquence de 32 kHz. Pour obtenir la fréquence de 2 kHz recherchée, on peut utiliser une chaîne de division qui va diviser par seize la fréquence d'oscillation de l'oscillateur à quartz. On peut également programmer le microprocesseur MP de la montre émettrice 26 de sorte que, à chaque fois que ledit microprocesseur MP comptera seize impulsions fournies par l'oscillateur à quartz, il commandera l'inversion de la polarité du signal de commande appliqué à la base du transistor T_{R3} de ladite montre émettrice 26.

La réponse du circuit convertisseur 20 de la montre réceptrice 28 est représentée à la figure 14. On voit que, sous l'effet du train d'ondes acoustiques produit par la montre émettrice 26, la tension au point de connexion "b" du vibreur piézo-électrique P₃ de la montre réceptrice 28 se met à osciller de part et d'autre de sa tension d'alimentation +E (courbe B, figure 14). Comme déjà expliqué ci-dessus, à chaque fois que la tension produite par le vibreur piézo-électrique P₃ excède sa tension de repos +E, le comparateur COMP de la montre réceptrice 28 va produire un signal impulsionnel à sa sortie "d" (courbe D, figure 14). On transforme ainsi l'onde acoustique produite par la montre émettrice 26 en un signal pseudo-numérique apte à commander le microprocesseur MP de la montre réceptrice 28 comme il va être expliqué ci-dessous. On remarquera que le signal impulsionnel produit par le comparateur COMP de la montre réceptrice 28 présente une forme analogue à celle du signal impulsionnel de commande appliqué au transistor T_{R3} de la montre émettrice 26, à l'exception de pics parasites désignés par la référence 38 qui peuvent apparaître entre deux "bips" sonores successifs sous l'effet du bruit ambiant capté par le vibreur piézo-électrique P₃ de ladite montre réceptrice 28.

Aussi longtemps que le système montre émettrice 26/montre réceptrice 28 est au repos, le microprocesseur MP de la montre réceptrice 28 reste en attente. Dès que la montre émettrice 26 envoie un premier "bip" sonore, le microprocesseur MP de la montre réceptrice 28 commande le démarrage d'un compteur de temps. En même temps, il compte le nombre d'impulsions logiques produites par le comparateur COMP et détermine par lecture dans un compteur s'il s'agit d'un niveau logique "0" ou "1".

A titre d'exemple uniquement, on suppose que la durée d'un "bip" sonore long sera de 100 ms, tandis que la durée d'un "bip" sonore court sera de 20 ms. Comme la fréquence du signal impulsionnel de commande du transistor TR3 de la montre émettrice 26 est de 2 kHz, le comparateur COMP de la montre réceptrice 28 produira 200 impulsions en réponse à un "bip" sonore long, et 40 impulsions en réponse à un "bip" sonore court. Toujours à titre d'exemple seulement, on suppose qu'un "bip" long correspondra à un "1" logique, tandis qu'un "bip" court correspondra à un "0" logique. On notera que les signaux parasites présents à chaque transition de "0" à "1" ou de "1" à "0" en sortie du comparateur COMP de la montre réceptrice 28 doivent être filtrés à l'entrée du microprocesseur MP, par exemple au moyen d'un filtre digital. Ainsi, au bout des vingt premières millisecondes, le microprocesseur MP de la montre réceptrice 28 aura compté quarante impulsions. On définit alors une plage dite de "silence" dont la durée peut être, par exemple, de 10 ms. Cette plage de silence permet de séparer distinctement les niveaux logiques "0" et "1" envoyés successivement au microprocesseur MP, et correspond à une période de temps durant laquelle la montre émettrice 26 n'envoie pas de "bip" sonore. Le microprocesseur MP de la montre réceptrice 28 n'enregistre ainsi plus d'impulsions, ou seulement un nombre aléatoire d'impulsions dues au seul bruit ambiant capté par le vibreur piézo-électrique P3 de la montre réceptrice 28. Par conséquent, si après les vingt premières millisecondes durant lesquelles quarante impulsions ont été envoyées, succède une plage de silence de 10 ms, le microprocesseur MP de la montre réceptrice 28 en déduira qu'il s'agit d'un "0" logique. Inversement, si pendant les 20 ms suivantes, le microprocesseur MP reçoit quarante impulsions supplémentaires, il en déduira qu'il ne s'agit pas d'un "0" logique, et restera dans l'attente des impulsions suivantes nécessaires pour former un "1" logique. On notera que l'on peut accepter un certain seuil de tolérance dans la transmission des impulsions vers le microprocesseur MP. Par exemple, 200 impulsions plus ou moins 10 impulsions transmises pendant 100 ms, suivies de 10 ms de silence correspondront à un "1" logique.

Dans l'exemple décrit ci-dessus, la durée d'un "bip" long est de 100 ms, celle d'un "bip" court est de 20 ms, et la durée de la plage de silence séparant deux "bips" successifs est de 10 ms. Une analyse statistique simple permet de déduire que le débit d'informations entre les montres émettrice 26 et réceptrice 28 sera de l'ordre de 10 bits/seconde environ. On comprendra, bien entendu, que pour des durées de "bips" sonores différentes, des débits de transmission bien supérieurs à 10 bits/seconde peuvent être obtenus.

Comme on l'a vu dans ce qui précède, il est possible, grâce à la présente invention, de transformer des "bips" sonores produits par un premier objet, en niveaux logiques "0" ou "1" aptes à commander le microprocesseur d'un second objet placé à distance du premier. Ce transfert de données peut s'effectuer entre deux montres électroniques, par exemple, ou encore entre une montre et un ordinateur. Un exemple d'application d'un tel système se rapporte à la mise à l'heure d'une montre. Le porteur de la montre se connecte sur le site Internet du fabricant de ladite montre et active la fonction de mise à l'heure offerte par ce site. L'ordinateur, équipé d'une carte son, va alors émettre une succession de "bips" sonores qui correspondront à autant de niveaux logiques "0" et "1" qui pourront être compris par le microprocesseur équipant la montre et permettront à ce dernier de commander la mise à l'heure de ladite montre. Inversement, on peut envisager de transférer des données depuis la montre vers l'ordinateur. Il peut s'agir d'un code conservé en mémoire dans la montre et permettant de participer gratuitement à un tirage au sort accompagné de lots organisé sur le site Internet du fabricant horloger. Tous types de données personnelles ou autres peuvent également être échangées entre deux montres.

On décrira enfin, à titre d'exemple toujours, un deuxième mode de conversion d'un signal sonore en données pseudo-numériques aptes à commander les fonctions d'un microprocesseur. Il s'agit du codage à modulation de fréquence communément appelé "FSK" (Frequency Shift Keying) représenté à la figure 15. Dans ce cas, la durée d'une impulsion sonore est fixe, par exemple égale à 100 ms, et c'est la fréquence du signal de commande appliqué à la base du transistor T_{R3} de la montre émettrice 26 qui varie. Par exemple, une fréquence de 1,5 kHz correspondra à un "0" logique, tandis qu'une fréquence de 2,5 kHz correspondra à un "1" logique. Le microprocesseur MP de la montre réceptrice 28 comptera ainsi le nombre d'impulsions reçues toutes les 100 ms, et en déduira s'il s'agit d'un "0" ou d'un "1" logique. L'un des avantages du codage à modulation de fréquence est que deux bits d'information successifs ne sont séparés par aucune plage de silence.

Il va de soi que l'invention n'est pas limitée au mode de réalisation qui vient d'être décrit, et que des modifications et des variantes peuvent être envisagées sans sortir du cadre de l'invention.

## Revendications

1. Convertisseur électronique (20) comprenant un circuit générateur de son (22) muni d'un vibreur piézo-électrique (P₃) ainsi que des moyens fournissant une tension de référence et des moyens de comparaison qui comparent la tension de référence à la tension produite par le vibreur piézo-électrique (P₃) lorsque celui-ci capte une onde acoustique, **caractérisé en ce que** lesdits moyens de comparaison produisent un signal pseudo-numérique lorsque la tension produite par ledit vibreur (P₃) excède la tension de référence.

2. Convertisseur selon la revendication 1, **caractérisé en ce que** la tension de référence est la tension d'alimentation (E) qui permet de faire circuler un courant dans le circuit générateur de son (22).

3. Convertisseur selon l'une quelconque des revendications 1 ou 2, **caractérisé en ce que** les moyens de comparaison comprennent un comparateur analogique-digital (COMP).

4. Convertisseur selon l'une quelconque des revendications 1 à 3, **caractérisé en ce que** le signal pseudo-numérique produit par les moyens de comparaison est utilisé pour commander les fonctions d'un microprocesseur (MP).

5. Convertisseur selon l'une quelconque des revendications 1 à 4, **caractérisé en ce que** le circuit générateur de son (22) comprend des moyens de commutation agencés pour s'enclencher et se déclencher sur réception d'un signal impulsionnel de commande (V_{CC}) et une branche de circuit dans laquelle une bobine (L₃) et une diode (D₃) sont montées en série, une résistance (R') et le vibreur piézo-électrique (P₃) étant raccordés en parallèle sur ladite branche de circuit.

6. Convertisseur selon la revendication 5, **caractérisé en ce que** les moyens de commutation comprennent un transistor (TR₃).

7. Convertisseur selon l'une quelconque des revendications 5 ou 6, **caractérisé en ce que** la tension de commande (V_{CC}) est égale à 3 V, **en ce que** la capacité des vibreurs piézo-électriques (P₃) est de l'ordre de 10 nF, et **en ce que** l'inductance des bobines (L₃) est de l'ordre de 50 mH.

8. Convertisseur selon la revendication 7, **caractérisé en ce que** la caractéristique de transfert en fonction de la fréquence de ce convertisseur (20) est centrée sur une fréquence de 2,4 kHz, et **en ce que** la largeur de la bande passante de ladite caractéristique de transfert est de l'ordre de 1 kHz.

9. Pièce d'horlogerie comportant un convertisseur électronique (20) selon l'une quelconque des revendications 1 à 8.

10. Procédé de communication bidirectionnelle par ondes acoustiques entre un instrument émetteur (26) et un instrument récepteur (28), chacun de ces deux instruments (26, 28) comportant un microprocesseur (MP) et un convertisseur électronique (20), ledit convertisseur (20) comprenant un circuit générateur de son (22) muni d'un vibreur piézo-électrique (P₃) ainsi que des moyens fournissant une tension de référence, où
- le circuit générateur de son (22) comprend des moyens de commutation agencés pour s'enclencher et se déclencher sur réception d'un signal impulsionnel de commande (V_{CC});
- le convertisseur électronique (20) comprend en outre des moyens de comparaison qui comparent la tension de référence à la tension produite par le vibreur piézo-électrique (P₃) lorsque celui-ci capte une onde acoustique, ces moyens de comparaison produisant un signal pseudo-numérique formé d'une succession d'impulsions logiques lorsque la tension produite par ledit vibreur (P₃) excède la tension de référence;
- aussi longtemps que l'émetteur (26) et le récepteur (28) sont au repos, le microprocesseur (MP) du récepteur (28) reste en attente d'un signal sonore;
- dès que l'émetteur (26) envoie le premier d'une série de "bips" sonores successifs, le microprocesseur (MP) du récepteur (28) commande le démarrage d'un compteur de temps, et commence à compter le nombre d'impulsions logiques produites par les moyens de comparaison, de sorte que ledit microprocesseur (MP) peut calculer le nombre d'impulsions reçues dans un intervalle de temps donné, et déterminer par lecture dans un compteur s'il s'agit d'un niveau logique "0" ou "1".

11. Procédé selon la revendication 10, **caractérisé en ce que** chaque niveau logique "0" ou "1" correspond à un "bip" long ou à un "bip" court, deux "bips" sonores successifs étant séparés par une plage de silence pendant laquelle l'émetteur (26) n'émet pas.

12. Procédé selon la revendication 11, **caractérisé en ce que** la fréquence du signal impulsionnel de commande (V_{CC}) appliqué aux moyens de commutation de l'émetteur (26) est de 2 kHz, **en ce que** la durée d'un "bip" court est de 20 ms et la durée d'un "bip" long est de 100 ms, et **en ce que** la durée de la plage de silence séparant deux "bips" successifs est de 10 ms.

13. Procédé selon la revendication 10, **caractérisé en ce que** l'on utilise le codage à modulation de fréquence "FSK".

14. Procédé selon la revendication 13, **caractérisé en ce que** la durée des "bips" sonores émis par l'émetteur (26) est de 100 ms, et **en ce que** la fréquence du signal impulsionnel de commande (V_{CC}) appliqué aux moyens de commutation de l'émetteur (26) est de 1,5 kHz pour un "bip" sonore correspondant à un niveau logique "0", et de 2,5 kHz pour un "bip" sonore correspondant à un niveau logique "1".

## Claims

1. Electronic converter (20) including a sound generator circuit (22) provided with a piezoelectric vibrator (P₃) as well as means supplying a reference voltage, and comparison means which compare the reference voltage to the voltage generated by the piezoelectric vibrator (P₃) when the latter picks up an acoustic wave, **characterised in that** said comparison means generate a pseudo-digital signal when the voltage generated by said vibrator (P₃) exceeds said reference voltage.

2. Converter according to claim 1, **characterised in that** the reference voltage is the supply voltage (E) which allows a current to flow in the sound generator circuit (22).

3. Converter according to any one of claims 1 or 2, **characterised in that** the comparison means include an analogue-digital comparator (COMP).

4. Converter according to any one of claims 1 to 3, **characterised in that** the pseudo-digital signal generated by the comparison means is used to control the functions of a microprocessor (MP).

5. Converter according to any one of claims 1 to 4, **characterised in that** the sound generator circuit (22) includes switching means arranged to be switched on and off upon receiving a control signal (V_{CC}), as well as a circuit branch in which a coil (L₃) and a diode (D₃) are mounted in series, a resistor (R') and the piezoelectric vibrator (P₃) being connected in parallel across said circuit branch.

6. Converter according to claim 5, **characterised in that** the switching means include a transistor (T_{R3}).

7. Converter according to any one of claims 5 or 6, **characterised in that** the control voltage (V_{CC}) is equal to 3 V, **in that** the capacitance of the piezoelectric vibrators (P₃) is of the order of 10 nF, and **in that** the inductance of the coils (L₃) is of the order of 50 mH.

8. Converter according to claim 7, **characterised in that** the frequency-transfer characteristic of said converter (20) is centred on a frequency of 2.4 kHz, and **in that** the transmission bandwidth of said transfer characteristic is of the order of 1 kHz.

9. Timepiece including an electronic converter (20) according to any one of claims 1 to 8.

10. Two-directional communication method via acoustic waves between an emitter unit (26) and a receiver unit (28), each of these two units (26, 28) including a microprocessor (MP) and an electronic converter (20), said converter (20) including a sound generator circuit (22) provided with a piezoelectric vibrator (P₃) as well as means supplying a reference voltage, where
- the sound generator circuit (22) includes switching means arranged to be switched on and off on receiving a pulsed control signal (V_{CC});
- the electronic converter (20) also includes comparison means which compare the reference voltage to a voltage generated by the piezoelectric vibrator (P₃) when the latter picks up an acoustic wave, these comparison means generating a pseudo-digital signal formed of a succession of logic pulses when the voltage generated by said vibrator (P₃) exceeds the reference voltage;
- as long as the emitter (26) and receiver (28) are idle, the microprocessor (MP) of the receiver (28) waits for a sound signal;
- as soon as the emitter (26) sends the first of a series of successive acoustic " beeps", the microprocessor (MP) of the receiver (28) instructs a time counter to start and begins to count the number of logic pulses generated by the comparison means, so that said microprocessor (MP) can calculate the number of pulses received in a given time interval, and determine by reading in a counter whether the logic level is " 0 " or " 1 ".

11. Method according to claim 10, **characterised in that** each " 0 "or" 1 " logic level corresponds to a long " beep " or a short " beep ", two successive acoustic " beeps " being separated by a silent period during which the emitter (26) does not emit.

12. Method according to claim 11, **characterised in that** the frequency of the pulsed control signal (V_{CC}) applied to the switching means of the emitter (26) is 2 kHz, **in that** the duration of a short " beep " is 20 ms and the duration of a long " beep " is 100 ms, and **in that** the duration of the silent period separating two successive "beeps " is 10 ms.

13. Method according to claim 10, **characterised in that** frequency shift keying "FSK " coding is used.

14. Method according to claim 13, **characterised in that** the duration of the acoustic "beeps"emitted by the emitter (26) is 100 ms, and **in that** the frequency of the pulsed control signal (V_{CC}) applied to the switching means of the emitter (26) is 1.5 kHz for an acoustic "beep" corresponding to a " 0 " logic level, and 2.5 kHz for an acoustic " beep " corresponding to a " 1 " logic level.

## Patentansprüche

1. Elektronischer Wandler (20) umfassend einen Schallgeneratorkreis (22) versehen mit einem Schwingpiezokristall (P₃) sowie Mittel zum Bereitstellen einer Referenzspannung und Vergleichsmittel, die die Referenzspannung mit der von dem Schwingpiezokristall erzeugten Spannung vergleichen, wenn dieser eine Schallwelle empfängt, **dadurch gekennzeichnet, daß** die Vergleichsmittel ein pseudo-digitales Signal erzeugen, wenn die von dem Schwinger (P₃) erzeugte Spannung die Referenzspannung übersteigt.

2. Wandler nach Anspruch 1, **dadurch gekennzeichnet, daß** die Referenzspannung die Versorgungsspannung (E) ist, die erlaubt, einen Strom in dem Schallgeneratorkreis (22) fließen zu lassen.

3. Wandler nach Anspruch 1 oder 2, **dadurch gekennzeichnet, daß** die Vergleichsmittel einen Analog-Digital-Komparator (COMP) umfassen.

4. Wandler nach einem der Ansprüche 1 bis 3, **dadurch gekennzeichnet, daß** das durch die Vergleichsmittel erzeugte pseudo-digitale Signal verwendet wird, um die Funktionen eines Mikroprozessors (MP) zu steuern.

5. Wandler nach einem der Ansprüche 1 bis 4, **dadurch gekennzeichnet, daß** der Schallgeneratorkreis (22) Kommutationsmittel aufweist, die aufgebaut sind, um sich einzuschalten und sich auszuschalten bei Empfang eines Steuerimpulskennzeichens (V_{CC}), und einen Schaltkreis (2), in dem eine Spule (L₃) und eine Diode (D₃) in Reihe geschaltet sind, wobei ein Widerstand (R') und der Schwingpiezokristall (P₃) parallel zum Schaltkreiszweig geschaltet sind.

6. Wandler nach Anspruch 5, **dadurch gekennzeichnet, daß** die Kommutationsmittel einen Transistor (TR₃) aufweisen.

7. Wandler nach Anspruch 5 oder 6, **dadurch gekennzeichnet, daß** die Steuerspannung (V_{CC}) gleich 3 V ist, daß die Kapazität des Schwingpiezokristalls (P₃) in der Größenordnung von 10 nF ist und daß die Induktivität der Spule (L₃) in der Größenordnung von 50 mH ist.

8. Wandler nach Anspruch 7, **dadurch gekennzeichnet, daß** die Übertragungscharakteristik in Abhängigkeit des Wandlers (20) um eine Frequenz von 2,4 kHz zentriert ist und daß die Breite des Bandes der Übertragungscharakteristik in der Größenordnung von 1 kHz ist.

9. Zeitmeßgerät, aufweisend einen elektronischen Wandler (20) nach einem der Ansprüche 1 bis 8.

10. Verfahren zum bidirektionalen Kommunizieren durch Schallwellen zwischen einer Sendevorrichtung (26) und einer Empfangsvorrichtung (28), wobei jede der beiden Vorrichtungen (26, 28) einen Mikroprozessor (MP) und einen elektronischen Wandler (20) aufweist, wobei der Wandler (20) einen mit einem Schwingpiezokristall (P₃) versehenen Schallgeneratorkreis (22) sowie Mittel zum Bereitstellen einer Referenzspannung umfaßt, wobei
- der Schallgeneratorkreis (22) Kommutationsmittel aufweist, die aufgebaut sind, um sich einzuschalten und sich auszuschalten bei Empfang eines Steuerimpulskennzeichens (V_{CC});
- der elektronische Wandler (20) weiterhin Vergleichsmittel aufweist, die die Referenzspannung mit der durch den Schwingpiezokristall (P₃) erzeugten Spannung vergleichen, wenn dieser eine Schallwelle empfängt, und die Vergleichsmittel ein pseudo-digitales Signal erzeugen, das aus einer Folge von logischen Impulsen gebildet ist, wenn die durch den Schwinger (P₃) erzeugte Spannung die Referenzspannung übersteigt;
- solange der Sender (26) und der Empfänger (28) in Ruhe sind, der Mikroprozessor (MP) des Empfängers (28) auf ein Schallsignal wartet;
- sobald der Sender (26) das erste einer Serie von aufeinanderfolgenden "BIP"-Tönen abschickt, der Mikroprozessor (MP) des Empfängers (28) das Starten eines Zeitmessers steuert und beginnt, die Anzahl der durch die Vergleichsmittel erzeugten logischen Impulse zu zählen, derart, daß der Mikroprozessor (MP) die Anzahl der in einem vorgegebenen Zeitintervall empfangenen Impulse berechnen und durch Lesen in einem Zähler bestimmen kann, ob es sich um einen logischen Pegel von "0" oder "1" handelt.

11. Verfahren nach Anspruch 10, **dadurch gekennzeichnet, daß** jeder logische Pegel "0" oder "1" einem langen "BIP" oder einem kurzen "BIP" entspricht, wobei zwei aufeinanderfolgende "BIP"-Töne durch einen Ruhebereich getrennt sind, während dessen der Sender (26) nicht sendet.

12. Verfahren nach Anspruch 11, **dadurch gekennzeichnet, daß** die auf die Kommutationsmittel des Senders (26) angewendete Frequenz des Steuerimpulskennzeichens (V_{CC}) 2 kHz ist, daß die Dauer eines kurzen "BIP" 20 ms ist und die Dauer eines langen "BIP" 100 ms ist und daß die Dauer eines zwei aufeinanderfolgende "BIPs" trennenden Ruhebereichs 10 ms ist.

13. Verfahren nach Anspruch 10, **dadurch gekennzeichnet, daß** zur Modulationskodierung der Frequenz "FSK" verwendet wird.

14. Verfahren nach Anspruch 13, **dadurch gekennzeichnet, daß** die Dauer der durch den Sender (26) ausgesendeten "BIP"-Töne 100 ms ist, und daß die Frequenz des Steuerimpulskennzeichens (V_{CC}), das auf die Kommutationsmittel des Senders (26) angewendet wird, 1,5 kHz ist für einen "BIP"-Ton, der einem logischen Pegel "0" entspricht, und 2,5 kHz ist für einen "BIP"-Ton, der einem logischen Pegel "1" entspricht.
